# EUROPEAN PATENT SPECIFICATION

(11) **EP 2 509 173 B1**
(45) Date of publication and mention of the grant of the patent: **20.09.2017**
(21) Application number: 11161313.9
(22) Date of filing: 06.04.2011
(51) Int. Cl.: H04B 10/90

(54) **Terahertz system**
Terahertz-System
Système de térahertz

(43) Date of publication of application: 10.10.2012
(73) Proprietor: Fraunhofer-Gesellschaft zur Förderung der angewandten Forschung e.V., 80686 München (DE)
(72) Inventor: Sartorius, Bernd, 14052, Berlin (DE)
(74) Representative: Maikowski & Ninnemann Patentanwälte Partnerschaft mbB

(56) References cited:
- WO-A1-2007/085573
- WO-A2-2008/067957
- KR-A- 20080 096 634
- US-A1- 2005 129 361
- US-A1- 2010 142 571
- LI W ET AL: "Multiwavelength Gain-Coupled DFB Laser Cascade: Design Modeling and Simulation", IEEE JOURNAL OF QUANTUM ELECTRONICS, IEEE SERVICE CENTER, PISCATAWAY, NJ, USA, vol. 36, no. 10, 1 October 2000 (2000-10-01), XP011052500, ISSN: 0018-9197
- LIMA C R ET AL: "Compact optical millimetre-wave source using a dual-mode semiconductor laser", ELECTRONICS LETTERS, IEE STEVENAGE, GB, vol. 31, no. 5, 2 March 1995 (1995-03-02), pages 364-366, XP006002495, ISSN: 0013-5194, DOI: 10.1049/EL:19950237
- XINHONG WANG ET AL: "Optical Generation of Microwave/Millimeter-Wave Signals Using Two-Section Gain-Coupled DFB Lasers", IEEE PHOTONICS TECHNOLOGY LETTERS, IEEE SERVICE CENTER, PISCATAWAY, NJ, US, vol. 11, no. 10, 1 October 1999 (1999-10-01), XP011046806, ISSN: 1041-1135

## Description

The invention relates to a Terahertz system according to claim 1 and a use of a beat signal generating device according to claim 14.

It is known in the art to use optical beat signals for controlling Terahertz systems, i.e. for controlling a Terahertz transmitter and/or a Terahertz receiver. Terahertz electromagnetic radiation in the range between 0.1 THz and 10 THz can be employed in a variety of fields such as safety engineering or spectroscopy. A Terahertz system is disclosed, for example, in US 2010/0080505 A1. Further, KR 2008 0096634 A discloses a multi section DFB laser that includes a phase tuning section.

It is an object of the invention to provide a Terahertz system that can be produced as cost-effective as possible.

This problem is solved by the Terahertz system according to claim 1 and the use of a beat signal generating device according to claim 14. Embodiments of the invention are defined in the dependent claims.

According to the invention, a Terahertz system is provided, comprising a beat signal generating device which has
- a first monomode laser for generating radiation of a first wavelength;
- a second monomode laser for generating radiation of a second wavelength different from the first wavelength;
- a first and a second output port;
- a phase modulating unit for modifying both the phase of radiation generated by the first laser and the phase of radiation generated the second laser, wherein the beat signal generating device is configured in such a way that
- the radiation generated by the first laser is transmitted through the second laser and superposed with the radiation generated by the second laser at the second output port, and
- the radiation generated by the second laser is transmitted through the first laser and superposed with the radiation generated by the first laser at the first output port, such that
- a first beat signal will be emitted at the first output port and a second beat signal will be emitted at the second output port,
- wherein the first output port of the beat signal generating device is connected to a first component of the Terahertz system, wherein the first component is a Terahertz transmitter such that the first beat signal is supplied to the Terahertz transmitter, and the second output port of the beat signal generating device is connected to a second component of the Terahertz system, wherein the second component is a Terahertz receiver such that the second beat signal is supplied to the Terahertz receiver, wherein the phase between the first beat signal supplied to the Terahertz transmitter and the second beat signal supplied to the Terahertz receiver can be adjusted by means of the phase modulating unit.

The first laser thus is configured to be sufficiently transparent for the second wavelength and the second laser is configured to be sufficiently transparent for the first wavelength. For example, the transparency of the first and the second laser for the wavelength generated by the respective other laser is at least 70 %, at least 80 % or at least 90 %. Examples of suitable lasers will be discussed further below.

The two monomode lasers and the phase modulating unit may be formed by a semiconductor chip; for example the lasers and the phase modulating unit are integrally formed by a semiconductor chip. The chip integration may have the advantage that phase instabilities in light paths from the first and the second laser towards the first and the second output port affecting only one of the generated wavelengths are reduced or avoided. The two output ports may be formed by side facets of the chip (comprising a semiconductor substrate and material layers arranged on the substrate), wherein an anti-reflection coating may be arranged on at least one of the output ports (on the chip facets).

According to another embodiment of the invention, the beat signal generating device comprises a plurality of optical waveguides connecting the first laser to the first output port and to the phase modulating unit, respectively, and connecting the second laser to the second output port and to the phase modulating unit, respectively.

In other word, the phase modulating unit is arranged between the first and the second laser. For example, the waveguides are straight waveguides and are e.g. arranged along a common axis such that the waveguides form a straight waveguide whose axis runs through the two lasers and the phase modulating unit. Thus, the components (the lasers and the phase modulating unit) of the beat generating device are arranged in row without the use of bends and couplers such that the dimensions of the device are reduced compared to the known optical beat signal sources. For example, the beat generating device according to the invention occupies an area of at most approximately 1 mm x 0.3 mm.

The waveguides may also be integrated on a semiconductor chip (e.g. in the form of ridge or embedded waveguides). Also, the waveguides, the lasers and/or the phase modulating unit could be integrally formed. It is noted that the first and the second laser do not necessarily have to be connected to the phase modulating unit via straight waveguides. Other waveguides, in principle, could also be used, wherein, however, the (single) phase modulating unit is arranged and configured in such a way that it affects the first wavelength radiation differently than the second wavelength generation such that the phase between the first and the second beat signal can be adjusted.

Further more, it is possible that the first and/or the second laser adjoins the first and second output port (arranged, for example, in a facet of the chip) directly such that a separate waveguide between the first laser and the first output port or between the second laser and the second output port is not required. Similarly, the first and the second laser may adjoin the phase modulating unit directly such that a separate waveguide between the first laser and the phase modulating unit or between the second laser and the phase modulating unit is not necessary. However, the first laser, the second laser and/or the phase modulating unit may comprise a waveguide or may form a waveguide for guiding light through these components and for coupling light into the adjoining component(s).

According to yet another embodiment of the invention, the phase modulating unit is an electro-optical unit, wherein the unit comprises a waveguide through which light of the first and the second laser is guided and at least one electrode for applying a voltage across the waveguide and/or injecting a current into the waveguide. For example, the electro-optical unit is arranged between the first and the second laser. Applying a voltage to the electrode changes the refractive index in the waveguide of the phase modulating unit thereby modifying the phase of the light passing through the waveguide (i.e. the light generated by the first and the second laser). For example, the waveguide of the phase modulating unit is integrally formed with waveguides connecting the first and the second laser to the phase modulating unit. For example, the phase modulating unit comprises an electrical input port via which an electrical voltage with a frequency in the kHz to GHz range can be supplied to the electrode.

According to another refinement of the invention the first laser is a (first) DFB laser and the second laser is a (second) DFB laser, wherein the first DFB laser is configured to generate radiation on the long wavelength side of its stop band and the second DFB laser is configured to generate radiation on the short wavelength side of its stop band.

A DFB laser (distributed feedback laser) comprises a laser active medium and a Bragg grating arranged along the laser active medium wherein in the region of the Bragg wavelength of the grating the DFB laser comprises a stop band, i.e. a wavelength region of high reflectivity of the Bragg grating. For example, the stop band has a spectral width of several nanometers, e.g. 4 nm, if the Bragg grating possesses an average coupling coefficient. Further, a DFB laser (having a homogeneous Bragg grating) preferably emits in a first mode having a wavelength adjacent to the stop band on the short wavelength side of the stop band ("short wavelength mode") and in a second mode having a wavelength adjacent to the stop band on the long wavelength side of the stop band ("long wavelength mode"). The properties of DFB lasers, however, are well known in the art such that they will not be discussed in more detail.

In particular, the Bragg gratings of the first and the second DFB laser are configured in such a way that the radiation wavelength of the first DFB laser (i.e. the "first wavelength") lies outside the stop band region of the second DFB laser and the radiation wavelength of the second DFB laser (i.e. the "second wavelength") lies outside the stop band of the first DFB laser. For example, the Bragg gratings of the first and the second DFB laser are configured in such a way that the radiation generated by the first DFB laser has a shorter wavelength than the radiation generated by the second DFB laser; i.e. the Bragg wavelength of the grating of the first DFB laser is smaller than the Bragg wavelength of the grating of the second DFB laser.

It is noted that it is also possible that both the first and the second DFB laser are configured to generate radiation either on the short wavelength side or on the long wavelength side of the respective stop band. In that case the Bragg gratings of the lasers have to be configured in such a way that the emission wavelengths of the lasers differ from one another by at least the stop band width of one of the lasers in order to prevent that the emission of one of the lasers is blocked by the Bragg grating of the other laser. It is also conceivable that the first and/or the second DFB laser is of the λ/4 type whose emission wavelength lies in the middle of the stop band.

However, if smaller beat frequencies (for example below 500 GHz) shall be generated the first DFB laser will be set to emit on the long wavelength side of the stop band and the second DFB laser will be configured to emit on the short wavelength side of the stop band (or vice versa) as mentioned above. This configuration, in principle, allows to produce any beat frequency (e.g. also below 100 GHz) depending on the wavelength difference between the first and the second wavelength (and without the problem that the first or the second wavelength emission is blocked by the second or the first laser, respectively).

Several measures for realizing a monomode output of a DFB laser either of the short wavelength mode or the long wavelength mode exist. For example, DFB lasers with conventionally index coupled Bragg gratings will emit on the short wavelength side of the stop band due to the effect of longitudinal hole burning. Exciting the long wavelength mode of a DFB laser could be achieved by using a gain coupled (complex coupled) Bragg grating instead of an index coupled grating. A gain coupled grating can be fabricated, for example, by providing grooves that extend into the active layer of the section. Thus, the first DFB laser may have a gain coupled Bragg grating and the second DFB laser may have an index coupled Bragg grating in order to provide a first DFB laser emitting on the long wavelength side of the stop band and a second DFB laser emitting on the short wavelength side of the stop band.

Further more, the first DFB laser may comprise at least a first and a second section, each section having a first and a second Bragg grating, i.e. the laser is formed as a multisection DFB laser. The Bragg wavelengths and the widths of the stop bands (i.e. the coupling coefficients) of the first and the second Bragg grating differ in such a way that only the wavelengths of the long wavelength modes in the first and the second section compare, i.e. only the long wavelength modes of first and the second section overlap. Similarly, the second DFB laser can also be realized as a multisection DFB laser, wherein the Bragg grating are configured in such a way that only the short wavelength modes overlap.

A multisection (e.g. a two-section) DFB laser as the first and/or the second DFB laser may replace a DFB laser with a gain coupled Bragg grating, wherein the Bragg gratings of both sections may be formed as index coupled gratings such that no gain coupled grating has to be provided (such that the more difficult generation of a gain coupled grating is avoided). If both the first and the second DFB laser are realized as multisection DFB lasers, the Bragg grating of the sections are e.g. configured in such a way that the emission wavelength of one of the lasers in not blocked by the stop band of the other laser.

It is furthermore possible that the first and/or the second laser comprise means for tuning the wavelength of the radiation generated by these lasers. For example, the means for tuning comprise a heating assigned to the respective laser, for example a resistive heating.

In an example, the means for tuning permit to alter the Bragg wavelength of at least one of the first and the second Bragg grating of the first two-section DFB laser such that, for example an overlap of the long wavelength modes can be switched to an overlap of the short wavelength modes. Similarly, the Bragg wavelength of at least one of the first and the second section of the second laser can be altered such that the overlap of the short wavelength modes can be switched to an overlap of the long wavelength modes. This allows to switch the difference between the first and the second output wavelength of the beat generating device and thus to switch the beat frequency to different tuning range.

In particular, the means for tuning the wavelength can be configured in such a way that a first heating element is assigned to the first section of the first two-section DFB laser and a second heating element is assigned to the second section of the first laser such that the Bragg wavelength of the first and the second Bragg grating of the first laser can be altered independently from one another. Similarly, a first and a second heating element can be assigned to the first and the second section of the second two-section DFB laser. Using the heating elements, a predetermined mode switching can be carried out.

Also, the laser current injected into the active regions of the sections of the two-section DFB lasers could be controlled in such a way that the current can be set individually for each segment. For example, each section of the first and/or the second laser has an individual electrode, wherein the electrodes are controlled independently. By injecting different currents into the different sections of the laser the spectral position of the laser modes can be shifted, which can also be used for producing a switch between the short and the long wavelength mode and vice versa.

It is noted that the invention is, of course, not restricted to the use of DFB lasers as the first and/or the second laser. Rather, other kinds of lasers could be used such as DBR lasers that may have a Bragg reflector on both sides of the active medium. Also, it is not necessary to use semiconductor lasers. It is also possible that, for example, other solid state lasers or gas lasers are used, wherein the light between the first and the second laser and/or between the lasers and the phase modulating unit is at least partially not guided within a waveguide, but, for example, is a free laser beam.

The beat signal generating device could furthermore comprise a mode transforming device ("taper") that transforms the spatial intensity distribution of radiation generated by the first and/or a second laser into a modified spatial intensity distribution. This embodiment, in particular, refers to the embodiment comprising a first and a second laser integrated in a semiconductor chip. The mode transforming device reduces coupling losses upon coupling of light from a chip facet into, for example, an optical fibre. The mode transforming device transforms the spatial intensity distribution of light at an output side of an integrated waveguide to match (or at least to come close) the (transversal) mode of the optical fibre.

Further, the beat signal generating device may comprise an amplifying device for amplifying the radiation generated by the first and/or the second laser. Such an amplifying device may comprise a laser active region into which a current can be injected (via an electrode), the laser active section being coupled to the first and/or the second laser. In particular, an amplifying device is arranged between the first output port of the beat signal generating device and the first laser and/or between the second output port and the second laser. Using the amplifying device not only an increase of the output power can be realized but it is also possible that a predetermined output power can be set or the amplitude of the output signal can be modulated (in particular with a high frequency, e.g. in the kHz or Mhz region), for example, for producing a signal that can be supplied to a lock-in device.

The Terahertz system may be a continuous wave Terahertz system, wherein the second component may be a local oscillator of the Terahertz receiver. In particular, the Terahertz transmitter may comprise a photomixer to which a beat signal output via the first output port of the beat signal generating device is supplied, wherein upon receipt of the beat signal the photomixer produces a Terahertz signal that could be radiated via an antenna.

Moreover, the invention relates to the use of a beat signal generating device, especially as described above, the beat signal generating device comprising
- a first laser for generating radiation of a first wavelength;
- a second laser for generating radiation of a second wavelength different from the first wavelength;
- a first and a second output port;
- a phase modulating unit for modifying both the phase of radiation generated by the first laser and the phase of radiation generated the second laser, the phase modulating unit, for example, being arranged between the first and the second laser, wherein the beat signal generating device is configured in such a way that
- the radiation generated by the first laser is transmitted through the second laser and superposed with the radiation generated by the second laser at the second output port, and
- the radiation generated by the second laser is transmitted through the first laser and superposed with the radiation generated by the first laser at the first output port, such that a first beat signal will be emitted at the first output port and a second beat signal will be emitted at the second output port,
- wherein the beat signal generating device is used to control a Terahertz system, wherein the first output port of the beat signal generating device is connected to a first component of the Terahertz system and the second output port of the beat signal generating device is connected to a second component of the Terahertz system.
- the beat signal generating device is used to control a Terahertz system, wherein the first output port of the beat signal generating device is connected to a first component of the Terahertz system and the second output port of the beat signal generating device is connected to a second component of the Terahertz system, the first component being a Terahertz transmitter and the second component being a Terahertz receiver, wherein the first beat signal is supplied to the Terahertz transmitter and the second beat signal is supplied to the Terahertz receiver, and wherein the phase between the first and the second beat signal is adjusted by means of the phase modulating unit.

The second component may be a local oscillator of a Terahertz receiver as already set forth above.

Embodiments of the invention will be described in more detail hereinafter with reference to the drawings, in which:
- Fig. 1: schematically shows a beat signal generating device for a Terahertz system according to an embodiment of the invention;
- Fig. 2: shows the spectral characteristics of a DFB grating;
- Fig. 3: illustrates the spectral characteristics of two monomode DFB lasers used in a beat signal generating device for a Terahertz system according to another embodiment of the invention;
- Fig. 4: illustrates the spectral behaviour of the beat signal generating device considered in Fig. 3, wherein a phase section is arranged between the lasers;
- Fig. 5: illustrates the spectral behaviour of a beat generating device for a Terahertz system according to another embodiment of the invention, the device comprising two two-section DFB lasers;
- Fig. 6: illustrates the spectrum of Fig. 5 wherein the stop band of one of the lasers was shifted; and
- Fig. 7: illustrates a beat signal generating device for a Terahertz system according to yet another embodiment of the invention.

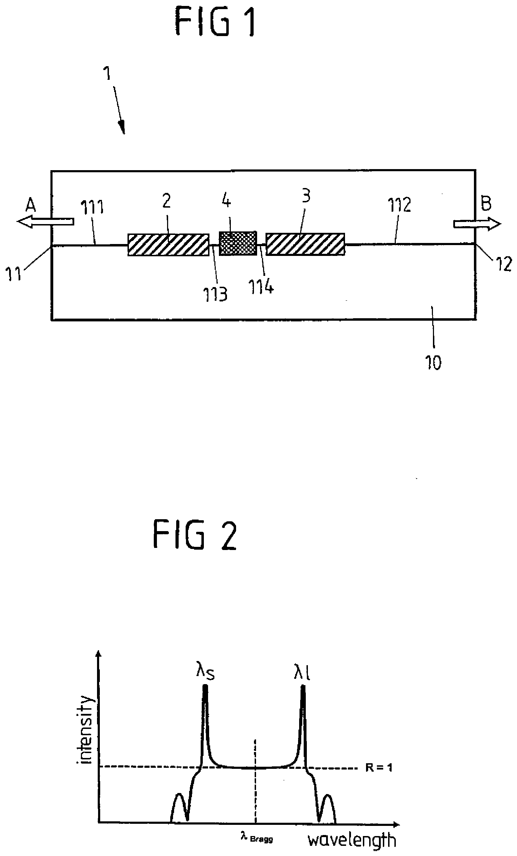

The beat signal generating device 1 for a Terahertz system according to the invention shown in Figure 1 comprises a first monomode laser 2 generating light radiation of a first wavelength and a second monomode laser 3 generating light radiation of a second wavelength different from the first wavelength. Arranged between the two lasers 2, 3 is a phase modulating unit 4 (phase section) that can be used to shift the phase of light generated by the lasers 2, 3 that passes through the unit 4.

The lasers 2, 3 and the phase modulating unit 4 are integrated on a semiconductor substrate such that the beat signal generating device 1 is formed as an optical chip 10. The beat signal generating device 1 further comprises a first output port 11 and a second output port 12 (formed, for example, by a facet of the chip 10), wherein an output side of the first laser 2 is connected to the first output port 11 via a first integrated waveguide 111. Similarly, the second laser 3 is connected to the second output port 12 via another integrated waveguide 112. Further integrated waveguides 113, 114 are provided between a second output side of the first laser 2 and the phase modulating unit 4 and between a second output side of the second laser 3 and the phase modulating unit 4, respectively. The waveguides 111 to 114 are straight waveguides aligned with one another. For example, the waveguides 111 to 114, the lasers 2, 3 and the phase modulating unit are integrally formed.

Thus, light of the first laser 2 will not only be guided towards the first output port 11 but also in opposite direction through the phase modulating unit 4 and through the second laser 3 towards the second output port 12. In order to allow light (having the first wavelength) from the first laser 2 to pass towards the second output port 12, the second laser 3 is sufficiently transparent for the first wavelength. Similarly, light of the second laser 3 will not only be guided towards the second output port 12 but also through the phase modulating unit 4 and the first laser 2 towards the first output port 11.

Therefore, at the first output port 11 light of the first laser 2 will be superposed with light of the second laser 3 (having travelled through the phase modulating unit 4 and the first laser 2) and at the second output port 12 another light portion generated by the first laser travelling through the phase modulating unit 4 and the second laser 3 will be superposed with light of the second laser 3. The superposition of the first and second wavelength light produces a first beat signal A at the first output port 11 and a second beat signal B at the second output port 12. The phase difference between the beat signals A, B at the first and the second output port 11, 12 can be adjusted by means of the phase modulating unit 4.

It is noted that only one phase modulating unit 4 is used for modifying the radiation of the two lasers 2, 3. However, as the light of the two lasers 2, 3 passes through the phase modulating unit 4 in opposite directions, the phase modulation adds to laser 2 in beat signal B and to laser 3 in beat signal A. The phase shift generated by the phase shifting unit 4 on the light waves produced by the first laser 2 and the second laser 3, respectively, thus will add up such that the relative phase of the beat signals A, B can be changed.

The beat signals A, B emitted at the output port 11 and 12, respectively, are fed into a photo mixer of a Terahertz transmitter and a photo mixer of a Terahertz receiver (not shown), respectively.

Suited lasers for the first and/or the second monomode lasers 2, 3 of the beat signal generating device may be DFB lasers, wherein a possible spectral behaviour of such a DFB laser is exemplarily shown in Figure 2. Around the Bragg wavelength *λ*_{Bragg} of the DFB laser's Bragg grating the laser comprises a stop band due to the high reflectivity of the Bragg grating in this wavelength region. The laser preferably emits radiation with a wavelength λₛ at the short wavelength side (short wavelength mode) of the stop band or with a wavelength λₗ on the long wavelength side (long wavelength mode) of the stop band.

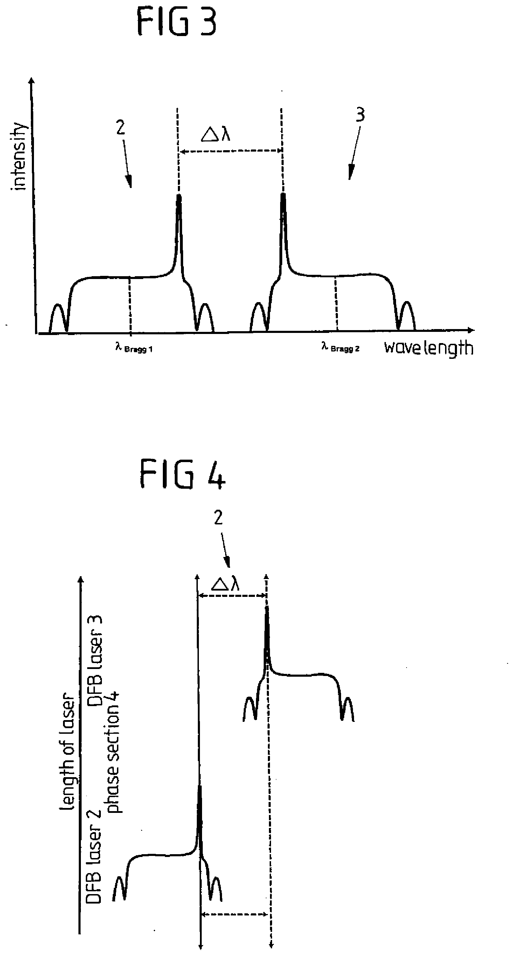

In order to achieve monomode lasing of a DFB laser one of the potential laser modes has to be suppressed. In the example shown in Figure 3 the first laser 2 is a DFB laser configured in such a way that only the mode at the long wavelength side of the stop band is excited, i.e. the "first wavelength" emitted by this laser is the wavelength of the long wavelength mode. For example, the first DFB laser 2 has a gain coupled Bragg grating. The second laser 3 lases only on the short wavelength side of the stop band, i.e. the "second wavelength" emitted by this laser is the wavelength of the short wavelength mode. For example, the second DFB laser has an index coupled Bragg grating.

Further, the Bragg gratings of the two DFB lasers 2, 3 are configured in such a way that the lasing wavelengths lie outside of the stop band of the other laser such that the light radiated by the first DFB laser 2 will be transmitted through the second DFB laser 3 and light generated by the second DFB laser 3 will be transmitted through the first DFB laser 2.

Figure 4 illustrates the two DFB lasers considered in Fig. 3, wherein a phase section 4 is arranged between the two DFB lasers.

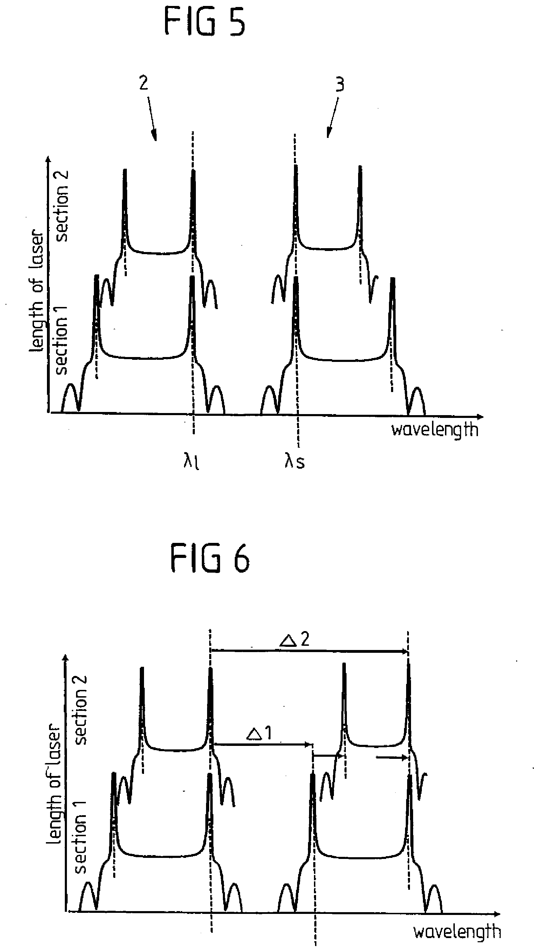

Figure 5 relates to another possibility of realising monomode lasers suited for a beat signal generating device. Both, the first and the second laser 2, 3 are implemented as a two section DFB laser. A two section DFB laser comprises a first DFB section comprising a first (index coupled) Bragg grating and a first laser active region and a second DFB section comprising a second (also index coupled) Bragg grating and a second laser active region.

The first and the second Bragg gratings of the first laser 2 are configured in such a way that they have different stop band widths and different Bragg wavelengths such that only the long wavelength modes in the first and the second DFB section overlap, i.e. the wavelength of the mode on the long wavelength side of the stop band in the first DFB section of laser 2 compares with the wavelength of the long wavelength mode in the second DFB section of laser 2 (wavelength λₗ). Especially, the Bragg grating of the second section (labelled "section 2" in Fig. 5) comprises a smaller coupling coefficient than the first section (labelled "section 1" in Fig. 5) and a longer Bragg wavelength. Thus, by choosing the properties of the Bragg gratings of the first and the second section monomode output can be created without having to use a gain coupled Bragg grating.

Similarly, the Bragg gratings of the second laser 3 are configured in such a way that only the short wavelength modes of the two sections overlap (wavelength λₛ). Thus, by using two two-section DFB lasers a first monomode laser and a second monomode DFB laser can be provided, wherein the first laser 2 is sufficiently transparent for letting pass the radiation of the second DFB laser 3 and vice versa.

At least one of the two two-section DFB lasers 2, 3 of Figure 5 could be equipped with means for tuning the output wavelength. For example, one of the two lasers 2, 3 comprises heating means, wherein for example a first heating element is assigned to the first Bragg grating section and a second heating element is assigned to the second Bragg grating section of the laser, wherein the heating elements can be controlled independently from one another such that the Bragg wavelength of at least one of the Bragg gratings can be shifted relative to the Bragg wavelength of the other Bragg grating as shown in Figure 6. Here, the Bragg wavelength of the Bragg grating of the second section of the second laser 3 is shifted towards a longer wavelength such that the overlap of the short wavelength modes at wavelength *λ*ₛ is shifted towards an overlap of the long wavelength modes. Thus, the wavelength difference between the first and the second wavelength generated by the first and the second lasers 2, 3 is changed from a value Δ1 to a larger value Δ2. Thus, the beat frequency is also changed such that when the beat signals are supplied to a Terahertz system the tuning range of the Terahertz system can be switched.

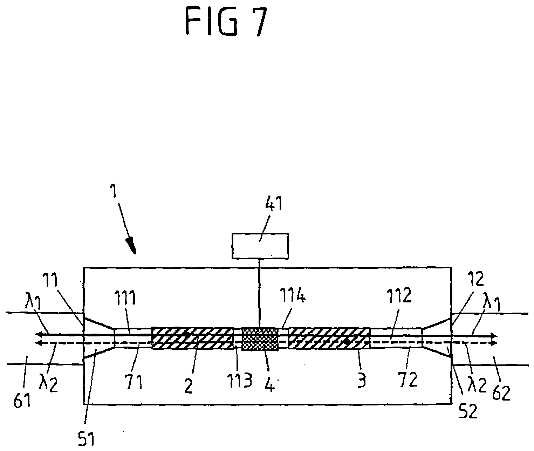

Figure 7 relates to another embodiment of the invention. The configuration compares to the configuration shown in Figure 1, i.e. the beat signal generating device 1 comprises a first and a second laser 2, 3 and a phase modulating unit 4 arranged between the lasers.

The phase modulating unit 4 comprises a waveguide to which an electrode is connected, wherein a voltage can be applied to the electrode using a voltage source 41 in order to change the refractive index of the waveguide. Similar to Figure 1, waveguides 111 - 114 are provided, wherein the waveguides 111 - 114, the lasers 2, 3 and the phase modulating unit are integrated in a semiconductor chip. At both output ports 11, 12 light generated by the first laser 2 (having the first wavelength λ₁) and light of the second laser 3 (having the second wavelength λ₂) will superpose.

In particular, the waveguides 111 to 114, the lasers 2, 3 and the phase modulating unit are formed by a single integrated waveguide that is structured in such a way that it forms the first and the second laser 2, 3 and the phase modulating unit 4. For example, the lasers 2, 3 comprise an active region and a Bragg grating that form part of the waveguide.

The beat generating device 1 further comprises two mode transforming devices in the form of a first and a second taper 51, 52 which are arranged between an ending of the waveguide 111 and the first output port 11 and an ending of the waveguide 112 and a second output port 12, respectively. The tapers 51, 52 are used to widen the optical mode guided in the waveguides 111, 112 in order to obtain a better overlap with the modes guided in an optical fiber 61, 62 coupled to the first and the second output port 11, 12, respectively.

Further, the beat generating device 1 comprises an amplifying device 71, 72 for amplifying light generated by the first and/or the second laser 2, 3, the amplifying device 71, 72 forming part of the waveguides 111, 112. The amplifying devices may comprises a first laser active section arranged in waveguide 111 and/or a second laser active section arranged in waveguide 112. It is possible that the laser active sections adjoin the first laser and the second laser (e.g. are integrally formed with the laser active region of the first and/or the second laser), respectively, wherein a common electrode may be provided for controlling both the laser active sections of the amplifying device and the first laser and the second laser, respectively. Of course, also separate electrodes can be used for the amplifying device and the first and the second laser, respectively.

### Reference signs

- 1: beat signal generating device
- 2: first laser
- 3: second laser
- 4: phase modulating unit
- 11: first output port
- 12: second output port
- 41: voltage source
- 51, 52: taper
- 61, 62: optical fibre
- 71, 72: amplifying device
- 111-114: waveguide

## Claims

1. Terahertz system, comprising a beat signal generating device (1) which has
- a first monomode laser (2) for generating radiation of a first wavelength (λ₁);
- a second monomode laser (3) for generating radiation of a second wavelength (λ₂) different from the first wavelength (λ₁);
- a first and a second output port (11, 12);
- a phase modulating unit (4) for modifying both the phase of radiation generated by the first laser and the phase of radiation generated the second laser (2, 3), wherein the beat signal generating device (1) is configured in such a way that
- the radiation generated by the first laser (2) is transmitted through the second laser (3) and superposed with the radiation generated by the second laser (2) at the second output port (12), and
- the radiation generated by the second laser (3) is transmitted through the first laser (2) and superposed with the radiation generated by the first laser (2) at the first output port (11), such that
- a first beat signal (A) will be emitted at the first output port (11) and a second beat signal (B) will be emitted at the second output port (12), , wherein the first output port (11) of the beat signal generating device (1) is connected to a first component of the Terahertz system, wherein the first component is a Terahertz transmitter such that the first beat signal (A) is supplied to the Terahertz transmitter,
**characterized in that**
the second output port (12) of the beat signal generating device (1) is connected to a second component of the Terahertz system, wherein the second component is a Terahertz receiver such that the second beat signal (B) is supplied to the Terahertz receiver, wherein the phase between the first beat signal (A) supplied to the Terahertz transmitter and the second beat signal (B) supplied to the Terahertz receiver can be adjusted by means of the phase modulating unit (4).

2. The Terahertz system as claimed in claim 1, further comprising a plurality of straight optical waveguides (111-114) connecting the first laser (2) to the first output port (11) and to the phase modulating unit (4), respectively, and connecting the second laser (3) to the second output port (12) and to the phase modulating unit (4), respectively.

3. The Terahertz system as claimed in claim 1 or 2, wherein the phase modulating unit (4) is an electro-optical phase modulating unit arranged between the first and the second laser (2, 3).

4. The Terahertz system as claimed in one of the preceding claims, wherein the first laser (2) is a first DFB laser and the second laser (3) is a second DFB laser, the Bragg gratings of the first and the second DFB laser being configured in such a way that the wavelength of the radiation generated by the first DFB laser lies outside the stopband of the second DFB laser and the wavelength of the radiation generated by the second DFB laser lies outside the stopband of the first DFB laser.

5. The Terahertz system as claimed in claim 4, wherein the first DFB laser is configured to generate radiation on the long wavelength side of its stop band and the second DFB laser is configured to generate radiation on the short wavelength side of its stop band.

6. The Terahertz system as claimed in claim 4 or 5, wherein the first DFB laser comprises a gain coupled Bragg grating.

7. The Terahertz system as claimed in one of the claims 4 to 6, wherein the second DFB laser comprises an index coupled Bragg grating.

8. The Terahertz system as claimed in one of the claims 4 to 7, wherein
- the first DFB laser comprises at least a first and a second section having a first and a second Bragg grating, wherein the Bragg wavelengths and the widths of the stop bands of the first and the second Bragg grating differ in such a way that only the wavelengths of the long wavelength modes in the first and the second section compare, and/or
- the second DFB laser comprises at least a first and a second section having a first and a second Bragg grating, wherein the Bragg wavelengths and the widths of the stop bands of the first and the second Bragg grating differ in such a way that only the wavelengths of the short wavelength modes in the first and the second section compare.

9. The Terahertz system as claimed in one of the preceding claims, wherein the first and/or the second laser (2, 3) comprises means for tuning the wavelength of the generated radiation.

10. The Terahertz system as claimed in claims 8 and 9, wherein the means for tuning the wavelength are configured in such a way that
- the Bragg wavelength of at least one of the first and the second Bragg grating of the first DFB laser can be altered such that the overlap of the long wavelength modes can be switched to an overlap of the short wavelength modes, and/or
- the Bragg wavelength of at least one of the first and the second Bragg grating of the second laser can be altered such that the overlap of the short wavelength modes can be switched to an overlap of the long wavelength modes.

11. The Terahertz system as claimed in claim 9 and 10, wherein the means for tuning the wavelength comprise
- a first heating element assigned to the first section of the first DFB laser and a second heating element assigned to the second section of the first DFB laser such that the Bragg wavelength of the first and the second Bragg grating of the first DFB laser can be altered independently from one another; and/or
- a first heating element assigned to the first section of the second DFB laser and a second heating element assigned to the second section of the second DFB laser such that the Bragg wavelength of the first and the second Bragg grating of the second DFB laser can be altered independently from one another.

12. The Terahertz system as claimed in one of the preceding claims, further comprising a mode transforming device (51, 52) for transforming the spatial intensity distribution of the radiation generated by the first and/or the second laser (2, 3) into a modified spatial intensity distribution.

13. The Terahertz system as claimed in one of the preceding claims, further comprising an amplifying device (71, 72) for amplifying the radiation generated by the first and/or the second laser (2, 3).

14. Use of a beat signal generating device (1), wherein the beat signal generating device (1) comprises
- a first laser (2) for generating radiation of a first wavelength (λ₁);
- a second laser (3) for generating radiation of a second wavelength (λ₂) different from the first wavelength (λ₁);
- a first and a second output port (11, 12);
- a phase modulating unit (4) for modifying both the phase of radiation generated by the first laser (2) and the phase of radiation generated the second laser (3), wherein the beat signal generating device (1) is configured in such a way that
- the radiation generated by the first laser (2) is transmitted through the second laser (3) and superposed with the radiation generated by the second laser (3) at the second output port (12), and
- the radiation generated by the second laser (3) is transmitted through the first laser (2) and superposed with the radiation generated by the first laser (2) at the first output port (11), such that a first beat signal (A) will be emitted at the first output port (11) and a second beat signal (B) will be emitted at the second output (12) port,
**characterized in that**
the beat signal generating device (1) is used to control a Terahertz system, wherein the first output port (11) of the beat signal generating device (1) is connected to a first component of the Terahertz system and the second output port (12) of the beat signal generating device (1) is connected to a second component of the Terahertz system, the first component being a Terahertz transmitter and the second component being a Terahertz receiver, wherein the first beat signal (A) is supplied to the Terahertz transmitter and the second beat signal (B) is supplied to the Terahertz receiver, and wherein the phase between the first and the second beat (A, B) signal is adjusted by means of the phase modulating unit (4).

## Patentansprüche

1. Terahertz-System, umfassend eine Schwebungssignal-Erzeugungsvorrichtung (1), die Folgendes aufweist:
- einen ersten Einmodenlaser (2) zum Erzeugen von Strahlung einer ersten Wellenlänge (λ₁);
- einen zweiten Einmodenlaser (3) zum Erzeugen von Strahlung einer zweiten Wellenlänge (λ₂), die von der ersten Wellenlänge (λ₁) verschieden ist;
- einen ersten und einen zweiten Ausgangsanschluss (11, 12);
- eine Phasenmodulationseinheit (4) zum Modifizieren sowohl der Phase der von dem ersten Laser erzeugten Strahlung als auch der Phase der von dem zweiten Laser (2, 3) erzeugten Strahlung, wobei die Schwebungssignal-Erzeugungsvorrichtung (1) so gestaltet ist, dass
- die von dem ersten Laser (2) erzeugte Strahlung durch den zweiten Laser (3) übertragen und mit der von dem zweiten Laser (3) erzeugten Strahlung an dem zweiten Ausgangsanschluss (12) überlagert wird, und
- die von dem zweiten Laser (3) erzeugte Strahlung durch den ersten Laser (2) übertragen und mit der von dem ersten Laser (2) erzeugten Strahlung an dem ersten Ausgangsanschluss (11) überlagert wird, so dass
- ein erstes Schwebungssignal (A) an dem ersten Ausgangsanschluss (11) abgegeben wird und ein zweites Schwebungssignal (B) an dem zweiten Ausgangsanschluss (12) abgegeben wird, wobei der erste Ausgangsanschluss (11) der Schwebungssignal-Erzeugungsvorrichtung (1) mit einer ersten Komponente des Terahertz-Systems verbunden ist, wobei die erste Komponente ein Terahertz-Sender ist, so dass das erste Schwebungssignal (A) dem Terahertz-Sender zugeführt wird,
**dadurch gekennzeichnet, dass**
der zweite Ausgangsanschluss (12) der Schwebungssignal-Erzeugungsvorrichtung (1) mit einer zweiten Komponente des Terahertz-Systems verbunden ist, wobei die zweite Komponente ein Terahertz-Empfänger ist, so dass das zweite Schwebungssignal (B) dem Terahertz-Empfänger zugeführt wird, wobei die Phase zwischen dem ersten Schwebungssignal (A), das dem Terahertz-Sender zugeführt wird, und dem zweiten Schwebungssignal (B), das dem Terahertz-Empfänger zugeführt wird, mit Hilfe der Phasenmodulationseinheit (4) eingestellt werden kann.

2. Terahertz-System nach Anspruch 1, ferner umfassend eine Vielzahl von geraden Lichtwellenleitern (111-114), die den ersten Laser (2) mit dem ersten Ausgangsanschluss (11) bzw. mit der Phasenmodulationseinheit (4) verbinden und den zweiten Laser (3) mit dem zweiten Ausgangsanschluss (12) bzw. mit der Phasenmodulationseinheit (4) verbinden.

3. Terahertz-System nach Anspruch 1 oder 2, wobei die Phasenmodulationseinheit (4) eine zwischen dem ersten und dem zweiten Laser (2, 3) angeordnete elektrooptische Phasenmodulationseinheit ist.

4. Terahertz-System nach einem der vorhergehenden Ansprüche, wobei der erste Laser (2) ein erster DFB-Laser ist und der zweite Laser (3) ein zweiter DFB-Laser ist, wobei die Bragg-Gitter des ersten und des zweiten DFB-Lasers so gestaltet sind, dass die Wellenlänge der von dem ersten DFB-Laser erzeugten Strahlung außerhalb des Stoppbandes des zweiten DFB-Lasers liegt und die Wellenlänge der von dem zweiten DFB-Laser erzeugten Strahlung außerhalb des Stoppbandes des ersten DFB-Lasers liegt.

5. Terahertz-System nach Anspruch 4, wobei der erste DFB-Laser so gestaltet ist, dass er Strahlung auf der langwelligen Seite seines Stoppbandes erzeugt und der zweiten DFB-Laser so gestaltet ist, dass er Strahlung auf der kurzwelligen Seite seines Stoppbandes erzeugt.

6. Terahertz-System nach Anspruch 4 oder 5, wobei der erste DFB-Laser ein verstärkungsgekoppeltes Bragg-Gitter umfasst.

7. Terahertz-System nach einem der Ansprüche 4 bis 6, wobei der zweite DFB-Laser ein indexgekoppeltes Bragg-Gitter umfasst.

8. Terahertz-System nach einem der Ansprüche 4 bis 7, wobei
- der erste DFB-Laser mindestens einen ersten und einen zweiten Abschnitt mit einem ersten und einem zweiten Bragg-Gitter umfasst, wobei sich die Bragg-Wellenlängen und die Breiten der Stoppbänder des ersten und des zweiten Bragg-Gitters so unterscheiden, dass nur die Wellenlängen der langwelligen Moden in dem ersten und dem zweiten Abschnitt vergleichbar sind, und/oder
- der zweite DFB-Laser mindestens einen ersten und einen zweiten Abschnitt mit einem ersten und einem zweiten Bragg-Gitter umfasst, wobei sich die Bragg-Wellenlängen und die Breiten der Stoppbänder des ersten und des zweiten Bragg-Gitters so unterscheiden, dass nur die Wellenlängen der kurzwelligen Moden in dem ersten und dem zweiten Abschnitt vergleichbar sind.

9. Terahertz-System nach einem der vorhergehenden Ansprüche, wobei der erste und/oder der zweite Laser (2, 3) Mittel zum Abstimmen der Wellenlänge der erzeugten Strahlung umfasst.

10. Terahertz-System nach Anspruch 8 und 9, wobei die Mittel zum Abstimmen der Wellenlänge so gestaltet sind, dass
- die Bragg-Wellenlänge mindestens eines von dem ersten und dem zweiten Bragg-Gitter des ersten DFB-Lasers so geändert werden kann, dass die Überlappung der langwelligen Moden auf eine Überlappung der kurzwelligen Moden umgeschaltet werden kann, und/oder
- die Bragg-Wellenlänge mindestens eines von dem ersten und dem zweiten Bragg-Gitter des zweiten Lasers so geändert werden kann, dass die Überlappung der kurzwelligen Moden auf eine Überlappung der langwelligen Moden umgeschaltet werden kann.

11. Terahertz-System nach Anspruch 9 und 10, wobei die Mittel zum Abstimmen der Wellenlänge Folgendes umfassen:
- ein erstes Heizelement, das dem ersten Abschnitt des ersten DFB-Lasers zugeordnet ist, und ein zweites Heizelement, das dem zweiten Abschnitt des ersten DFB-Lasers zugeordnet ist, so dass die Bragg-Wellenlänge des ersten und des zweiten Bragg-Gitters des ersten DFB-Lasers unabhängig voneinander geändert werden kann; und/oder
- ein erstes Heizelement, das dem ersten Abschnitt des zweiten DFB-Lasers zugeordnet ist, und ein zweites Heizelement, das dem zweiten Abschnitt des zweiten DFB-Lasers zugeordnet ist, so dass die Bragg-Wellenlänge des ersten und des zweiten Bragg-Gitters des zweiten DFB-Lasers unabhängig voneinander geändert werden kann.

12. Terahertz-System nach einem der vorhergehenden Ansprüche, ferner umfassend eine Modentransformationsvorrichtung (51, 52) zum Transformieren der räumlichen Intensitätsverteilung der durch den ersten und/oder den zweiten Laser (2, 3) erzeugten Strahlung in eine modifizierte räumliche Intensitätsverteilung.

13. Terahertz-System nach einem der vorhergehenden Ansprüche, ferner umfassend eine Verstärkungsvorrichtung (71, 72) zum Verstärken der durch den ersten und/oder den zweiten Laser (2, 3) erzeugten Strahlung.

14. Verwendung einer Schwebungssignal-Erzeugungsvorrichtung (1), wobei die Schwebungssignal-Erzeugungsvorrichtung (1) Folgendes umfasst:
- einen ersten Laser (2) zum Erzeugen von Strahlung einer ersten Wellenlänge (λ₁);
- einen zweiten Laser (3) zum Erzeugen von Strahlung einer zweiten Wellenlänge (λ₂), die von der ersten Wellenlänge (λ₁) verschieden ist;
- einen ersten und einen zweiten Ausgangsanschluss (11, 12);
- eine Phasenmodulationseinheit (4) zum Modifizieren sowohl der Phase der von dem ersten Laser (2) erzeugten Strahlung als auch der Phase der von dem zweiten Laser (3) erzeugten Strahlung, wobei die Schwebungssignal-Erzeugungsvorrichtung (1) so gestaltet ist, dass
- die von dem ersten Laser (2) erzeugte Strahlung durch den zweiten Laser (3) übertragen und mit der von dem zweiten Laser (3) erzeugten Strahlung an dem zweiten Ausgangsanschluss (12) überlagert wird, und
- die von dem zweiten Laser (3) erzeugte Strahlung durch den ersten Laser (2) übertragen und mit der von dem ersten Laser (2) erzeugten Strahlung an dem ersten Ausgangsanschluss (11) überlagert wird, so dass ein erstes Schwebungssignal (A) an dem ersten Ausgangsanschluss (11) abgegeben wird und ein zweites Schwebungssignal (B) an dem zweiten Ausgangsanschluss (12) abgegeben wird,
**dadurch gekennzeichnet, dass**
die Schwebungssignal-Erzeugungsvorrichtung (1) zur Steuerung eines Terahertz-Systems verwendet wird, wobei der erste Ausgangsanschluss (11) der Schwebungssignal-Erzeugungsvorrichtung (1) mit einer ersten Komponente des Terahertz-Systems verbunden ist und der zweite Ausgangsanschluss (12) der Schwebungssignal-Erzeugungsvorrichtung (1) mit einer zweiten Komponente des Terahertz-Systems verbunden ist, wobei die erste Komponente ein Terahertz-Sender ist und die zweite Komponente ein Terahertz-Empfänger ist, wobei das erste Schwebungssignal (A) dem Terahertz-Sender zugeführt wird und das zweite Schwebungssignal (B) dem Terahertz-Empfänger zugeführt wird, und wobei die Phase zwischen dem ersten und dem zweiten Schwebungssignal (A, B) mit Hilfe der Phasenmodulationseinheit (4) eingestellt wird.

## Revendications

1. Système de térahertz, comprenant un dispositif générant un signal de battement (1) qui a
- un premier laser monomode (2) pour générer un rayonnement d'une première longueur d'onde (λ₁) ;
- un second laser monomode (3) pour générer un rayonnement d'une seconde longueur d'onde (λ₂) différente de la première longueur d'onde (λ₁) ;
- un premier et un second port de sortie (11, 12) ;
- une unité de modulation de phase (4) pour modifier à la fois la phase de rayonnement généré par le premier laser et la phase de rayonnement généré par le second laser (2, 3), dans lequel le dispositif générant un signal de battement (1) est configuré de manière telle que
- le rayonnement généré par le premier laser (2) est transmis par le biais du second laser (3) et superposé au rayonnement généré par le second laser (2) au niveau du second port de sortie (12), et
- le rayonnement généré par le second laser (3) est transmis par le biais du premier laser (2) et superposé au rayonnement généré par le premier laser (2) au niveau du premier port de sortie (11), de sorte que
- un premier signal de battement (A) sera émis au niveau du premier port de sortie (11) et un second signal de battement (B) sera émis au niveau du second port de sortie (12), dans lequel le premier port de sortie (11) du dispositif générant un signal de battement (1) est connecté à un premier composant du système de térahertz, dans lequel le premier composant est un émetteur térahertz de sorte que le premier signal de battement (A) est fourni à l'émetteur térahertz,
**caractérisé en ce que**
le second port de sortie (12) du dispositif générant un signal de battement (1) est connecté à un second composant du système de térahertz, dans lequel le second composant est un récepteur térahertz de sorte que le second signal de battement (B) est fourni au récepteur térahertz, dans lequel la phase entre le premier signal de battement (A) fourni à l'émetteur térahertz et le second signal de battement (B) fourni au récepteur térahertz peut être ajustée au moyen de l'unité de modulation de phase (4).

2. Système de térahertz selon la revendication 1, comprenant en outre une pluralité de guides d'ondes optiques droits (111-114) connectant le premier laser (2) au premier port de sortie (11) et à l'unité de modulation de phase (4), respectivement, et connectant le second laser (3) au second port de sortie (12) et à l'unité de modulation de phase (4), respectivement.

3. Système de térahertz selon la revendication 1 ou 2, dans lequel l'unité de modulation de phase (4) est une unité de modulation de phase électrooptique disposée entre le premier et le second laser (2, 3).

4. Système de térahertz selon l'une quelconque des revendications précédentes, dans lequel le premier laser (2) est un premier laser DFB et le second laser (3) est un second laser DFB, les réseaux de Bragg du premier et du second laser DFB étant configurés de manière telle que la longueur d'onde du rayonnement généré par le premier laser DFB est située en dehors de la bande atténuée du second laser DFB et la longueur d'onde du rayonnement généré par le second laser DFB est située en dehors de la bande atténuée du premier laser DFB.

5. Système de térahertz selon la revendication 4, dans lequel le premier laser DFB est configuré pour générer un rayonnement sur le côté des longues longueurs d'onde de sa bande atténuée et le second laser DFB est configuré pour générer un rayonnement sur le côté des courtes longueurs d'onde de sa bande atténuée.

6. Système de térahertz selon la revendication 4 ou 5, dans lequel le premier laser DFB comprend un réseau de Bragg couplé à un gain.

7. Système de térahertz selon l'une quelconque des revendications 4 à 6, dans lequel le second laser DFB comprend un réseau de Bragg couplé à un indice.

8. Système de térahertz selon l'une quelconque des revendications 4 à 7, dans lequel
- le premier laser DFB comprend au moins une première et une seconde section ayant un premier et un second réseau de Bragg, dans lequel les longueurs d'onde de Bragg et les largeurs des bandes atténuées du premier et du second réseau de Bragg diffèrent de manière telle que seules les longueurs d'onde des modes à longues longueurs d'onde dans la première et la seconde section sont comparables, et/ou
- le second laser DFB comprend au moins une première et une seconde section ayant un premier et un second réseau de Bragg, dans lequel les longueurs d'ondes de Bragg et les largeurs des bandes atténuées du premier et du second réseau de Bragg diffèrent de manière telle que seules les longueurs d'onde des modes à courtes longueurs d'onde dans la première et la seconde section sont comparables.

9. Système de térahertz selon l'une quelconque des revendications précédentes, dans lequel le premier et/ou le second laser (2, 3) comprend un moyen pour régler la longueur d'onde du rayonnement généré.

10. Système de térahertz selon la revendication 8 et 9, dans lequel le moyen pour régler la longueur d'onde est configuré de manière telle que
- la longueur d'onde de Bragg d'au moins un du premier et du second réseau de Bragg du premier laser DFB peut être altérée de sorte que le chevauchement des modes à longues longueurs d'onde peut être commuté en un chevauchement des modes à courtes longueurs d'onde, et/ou
- la longueur d'onde de Bragg d'au moins un du premier et du second réseau de Bragg du second laser peut être altérée de sorte que le chevauchement des modes à courtes longueurs d'onde peut être commuté en un chevauchement des modes à longues longueurs d'onde.

11. Système de térahertz selon la revendication 9 et 10, dans lequel le moyen pour régler la longueur d'onde comprend
- un premier élément chauffant assigné à la première section du premier laser DFB et un second élément chauffant assigné à la seconde section du premier laser DFB de sorte que les longueurs d'onde de Bragg du premier et du second réseau de Bragg du premier laser DFB peuvent être altérées indépendamment l'une de l'autre ; et/ou
- un premier élément chauffant assigné à la première section du second laser DFB et un second élément chauffant assigné à la seconde section du second laser DFB de sorte que les longueurs d'onde de Bragg du premier et du second réseau de Bragg du second laser DFB peuvent être altérées indépendamment l'une de l'autre.

12. Système de térahertz selon l'une quelconque des revendications précédentes, comprenant en outre un dispositif de transformation de mode (51, 52) pour transformer la distribution d'intensité spatiale du rayonnement généré par le premier et/ou le second laser (2, 3) en une distribution d'intensité spatiale modifiée.

13. Système de térahertz selon l'une quelconque des revendications précédentes, comprenant en outre un dispositif d'amplification (71, 72) pour amplifier le rayonnement généré par le premier et/ou le second laser (2, 3).

14. Utilisation d'un dispositif générant un signal de battement (1), dans lequel le dispositif générant un signal de battement (1) comprend
- un premier laser (2) pour générer un rayonnement d'une première longueur d'onde (λ₁) ;
- un second laser (3) pour générer un rayonnement d'une seconde longueur d'onde (λ₂) différente de la première longueur d'onde (λ₁) ;
- un premier et un second port de sortie (11, 12) ;
- une unité de modulation de phase (4) pour modifier à la fois la phase de rayonnement généré par le premier laser (2) et la phase de rayonnement généré par le second laser (3), dans lequel le dispositif générant un signal de battement (1) est configuré de manière telle que
- le rayonnement généré par le premier laser (2) est transmis par le biais du second laser (3) et superposé au rayonnement généré par le second laser (3) au niveau du second port de sortie (12), et
- le rayonnement généré par le second laser (3) est transmis par le biais du premier laser (2) et superposé au rayonnement généré par le premier laser (2) au niveau du premier port de sortie (11), de sorte qu'un premier signal de battement (A) sera émis au niveau du premier port de sortie (11) et un second signal de battement (B) sera émis au niveau du second port de sortie (12),
**caractérisé en ce que**
le dispositif générant un signal de battement (1) est utilisé pour commander un système de térahertz, dans lequel le premier port de sortie (11) du dispositif générant un signal de battement (1) est connecté à un premier composant du système de térahertz et le second port de sortie (12) du dispositif générant un signal de battement (1) est connecté à un second composant du système de térahertz, le premier composant étant un émetteur térahertz et le second composant étant un récepteur térahertz, dans lequel le premier signal de battement (A) est fourni à l'émetteur térahertz et le second signal de battement (B) est fourni au récepteur térahertz, et dans lequel la phase entre le premier et le second signal de battement (A, B) est ajustée au moyen de l'unité de modulation de phase (4).
